# EUROPEAN PATENT APPLICATION

(11) **EP 1 316 993 A1**
(43) Date of publication of application: **04.06.2003**
(21) Application number: 02258192.0
(22) Date of filing: 28.11.2002
(51) Int. Cl.: H01L 21/308

(54) **Differential etching of semiconductors**

(30) Priority: 29.11.2001 GB 0128617
(71) Applicant: Denselight Semiconductors Pte Ltd., Singapore 498831 (SG)
(72) Inventor: Cha Cher Liang, Randall, 520302 Singapore (SG); Nakamura, Hiroshi, 529892 Singapore (SG); Lam, Yee Loy, 680271 Singapore (SG); Teo, Kian Hin Victor, 270008 Singapore (SG)
(74) Representative: Finnie, Peter John

(57) **Abstract**

A method for fabricating features of different depth in a semiconductor substrate by differential etching. Each of the features is first defined by a temporary mask and a metal layer is deposited and processed to provide a negative image of the original mask, the metal layer then acting as a protective layer during etching of the semiconductor substrate to fabricate the desired feature. The technique also allows the possibility that portions of two features of different depth may connect by opening into one another.

## Description

### Field of the Invention

The present invention relates to the fabrication of features in a semiconductor substrate and, in particular, by use of differential etching.

### Background to the Invention

The etching of silicon (Si) and III-V semiconductor substrates to fabricate multiple features in the substrate is a common process step. In particular, features such as V-grooves and trenches are commonly etched during the fabrication of micro-sensors and micro-actuators using micro-electrical-mechanical systems (MEMS). They are also widely employed in optical benches to house single-mode transmission fibres. Sometimes, a single V-groove is sufficient, but if a forward fibre movement stopper is required, a deep vertical trench is needed to act as the fibre stop. V-groove etching is achieved through the well-known process of wet chemical etching, while reactive-ion etching (RIE) or inductively coupled plasma (ICP) etching can be used to accomplish deep trench etching. Owing to the different conditions for each type of etch, different masks are necessary for each of the different etch steps. The masking and etching for the V-groove and trench are also not completed in a self-aligning manner.

### Summary of the Invention

According to a first aspect of the present invention, there is provided a method for fabricating features of different depth in a semiconductor substrate by differential etching, comprising the steps of:
applying a first mask to a surface of the substrate;
depositing a layer of a first metal, said layer covering the first mask and exposed regions of the substrate;
removing the first mask and regions of the first metal layer above the first mask;
applying a second mask to at least one of regions of the first metal layer and exposed regions of the substrate;
depositing a layer of a second metal, said layer covering the second mask, the first metal layer and any exposed regions of the substrate;
removing the second mask and regions of the second metal layer above the second mask;
forming a first feature in the substrate by etching exposed regions of the substrate;
removing the layer of the second metal by an etching process;
forming a second feature in the substrate by etching exposed regions of the substrate; and,
removing the layer of the first metal by an etching process.

The present invention provides a simple technique by which two sets of features of different depth may be fabricated in a semiconductor substrate. Each of the first and second metal layers provide a negative image of the corresponding original mask and act as a protective layer during etching of the semiconductor substrate to fabricate the desired features. The technique also allows the possibility that portions of the two features may connect by opening into one another.

A third metal layer may be applied on top of the second metal layer in order to provide greater protection and selectivity during the etching of deep features.

Preferably, the method further comprises the steps of:
depositing a layer of a third metal over the second metal layer, prior to removing the second mask;
removing the second mask and regions of the second and third metal layers above the second mask; and,
removing the layers of the third and second metal by an etching process after forming the first feature in the substrate.

Once the substrate has been etched, the relevant protective metal layer can be removed.

Preferably, the substrate is a silicon substrate.

Preferably, the metal layers are removed by a wet etching process.

The substrate may be etched using a dry etching process, wet etching process or a combination of the two processes in order to fabricate the desired features.

There are many combinations of different metals that are suitable as protective layers during the differential etching process.

Where three protective metal layers are employed, it is preferred that the first, second and third metals are Nickel (Ni), Gold (Au) and Titanium (Ti), respectively.

Alternatively, it is preferred that the first, second and third metals are Aluminium (Al), Gold (Au) and Chromium (Cr), respectively.

It is often desirable to deposit a buffer layer on the substrate prior to masking and etching the substrate.

Preferably, the method for fabricating features of different depth further comprising the steps of:
forming a buffer layer on the surface of the substrate prior to applying the first mask;
removing exposed regions of the buffer layer prior to forming each of the first and second features in the substrate; and,
removing the remaining buffer layer after removing the layer of the first metal.

Preferably, the buffer layer comprises a SiO₂ layer.

Preferably, at least a portion of the buffer layer is removed by a dry etching process.

According to a second aspect of the present invention, there is provided a semiconductor substrate with a v-groove and a deep trench stop, the deep trench stop being substantially perpendicular to the v-groove, said v-groove and deep trench stop fabricated by a method according to the first aspect of the present invention

### Brief Description of the Drawings

Examples of the present invention will now be described in detail with reference to the accompanying drawings, in which:

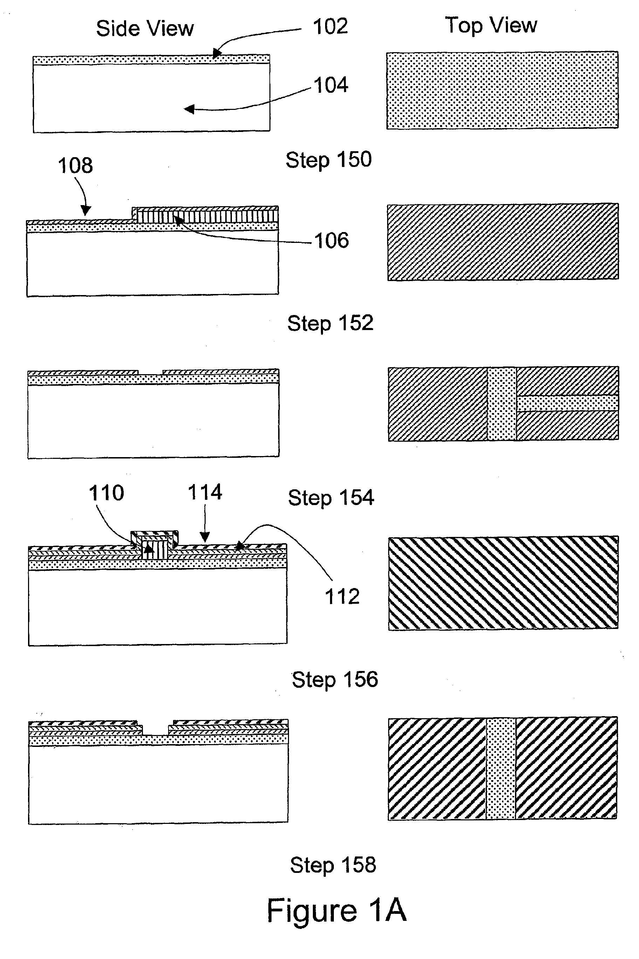

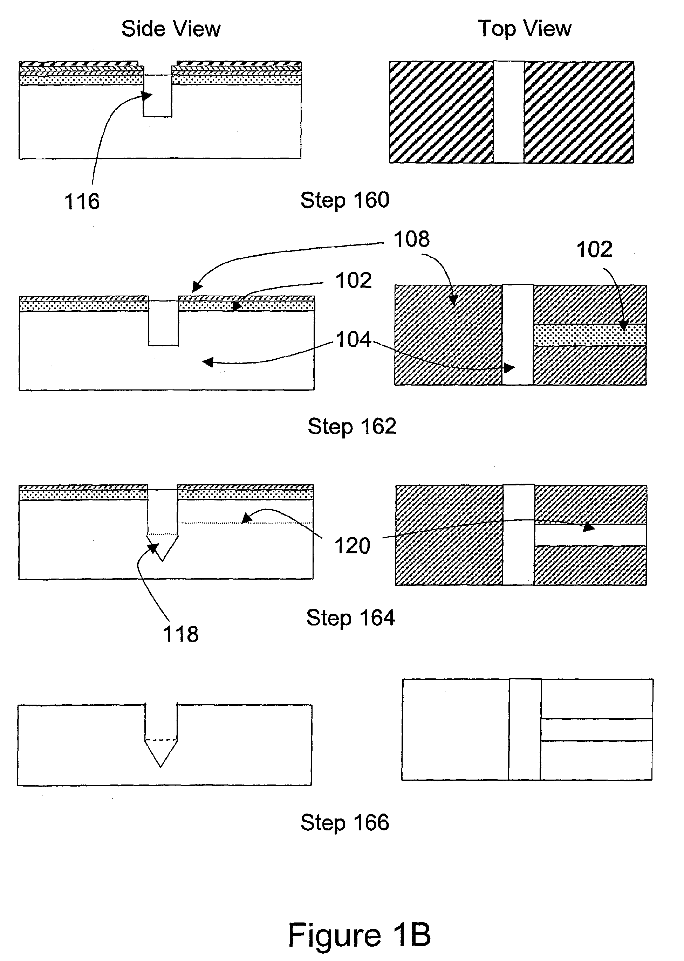

Figures 1A and 1B show successive stages of a method for fabricating a T-shaped feature in a silicon substrate in accordance with the present invention.

### Detailed Description

Figures 1A and 1B illustrate a case study showing both possible metal and semiconductor materials and the accompanied process flow for fabricating a T-shaped feature in a silicon substrate.

In the following discussion, respective masking steps are performed by metal deposition and lift-off. Although not illustrated, metal masking can also be performed by metal deposition and wet etching, if suitable etching agents are available.

The T-shaped feature provided on the substrate 102 in Figures 1A and 1B is constructed from two intersecting features (trenches). These features are of differing depths.

Step 150 (in Figure 1A) shows the optional formation of a buffer layer 104 over the substrate 102. In this case, the buffer layer is made of silicon dioxide and the substrate, of silicon. The buffer layer, when required, can be formed by conventional deposition or growth techniques.

In Step 152, a T-shaped mask 106 is applied to a surface of the substrate 102,104. A layer of a first metal 108 is deposited, covering both the T-shaped mask 106 and exposed regions of the substrate 102,104.

The T-shaped mask 106 is then removed (Step 154) together with regions of the first metal layer 108 above the mask 106

A second mask 110, in the shape of the "crossbar" of the previous T-shaped mask 106, is applied over the region of the crossbar of the T-shaped feature of exposed substrate 102,104 (Step 156). A second 112 and a third metal layer 114 are deposited over both the second mask 110, the first metal layer 108 and any exposed surface of the substrate 102,104. The third metal layer 114 is optional but improves the resistance of the surface to differential etching processes. In the illustrated embodiment, the first metal layer 108 is nickel, the second 112 is gold and the (optional) third is 114 titanium.

In step 158, the second mask 110 and regions of the second metal layer 112 (and the third layer 114, when present) above the second mask are removed leaving a crossbar-shaped feature of exposed substrate 102,104.

Step 160 (Figure 1B) shows the formation of a deep trench feature 116 in the substrate by the dry etching of exposed regions of the substrate. The metal layers 114,112,108 protect underlying regions from the etching process but the crossbar-shaped feature, where the substrate 102,104 is exposed, is etched deep into the silicon substrate 104.

A wet etch process is then used to remove the third metal layer 114 and the second metal layer 112, leaving the deep trench feature 116 and surrounding first metal layer 108 exposed (Step 162).

Step 164 shows the formation of a V-groove region feature in the substrate by etching exposed regions of the substrate 102,104. As before, the first metal layer prevents etching of the underlying regions. In this step, a T-shaped region is left exposed. A wet (chemical) etch process is used to form a V-groove 118 into the base of the deep trench feature 116 and to form a further trench 120 having a V-groove and ending at the (deeper) trench feature 116. Self-aligned V-groove etching is possible because of known properties of the crystalline structure of the substrate.

Finally, at step 166, the first metal layer 108 is removed by a final wet etching process. If any silicon dioxide buffer layer 102 remains, this too is stripped from the surface of the substrate.

In this embodiment of the invention, tri-layered metal masks are used to perform self-aligned V-groove and deep trench etching. Different numbers of metal layers can be used to protect specific regions during a plurality of wet and dry etching processes. The deepest trench will be formed where no metal is deposited. Shallower trenches can be formed using fewer layers of metal - just as the "vertical" of the T-shaped feature was. Where no etching is desired or required, sufficient metal layers are used to protect the underlying material.

## Claims

1. A method for fabricating features of different depth in a semiconductor substrate by differential etching, comprising the steps of:
applying a first mask to a surface of the substrate;
depositing a layer of a first metal, said layer covering the first mask and exposed regions of the substrate;
removing the first mask and regions of the first metal layer above the first mask;
applying a second mask to at least one of regions of the first metal layer and exposed regions of the substrate;
depositing a layer of a second metal, said layer covering the second mask, the first metal layer and any exposed regions of the substrate;
removing the second mask and regions of the second metal layer above the second mask;
forming a first feature in the substrate by etching exposed regions of the substrate;
removing the layer of the second metal by an etching process;
forming a second feature in the substrate by etching exposed regions of the substrate; and,
removing the layer of the first metal by an etching process.

2. A method according to claim 1, further comprising the steps of:
depositing a layer of a third metal over the second metal layer, prior to removing the second mask;
removing the second mask and regions of the second and third metal layers above the second mask; and,
removing the layers of the third and second metal by an etching process after forming the first feature in the substrate.

3. A method according to claim 1 or 2, in which the first feature extends to greater depth in the substrate than the second feature.

4. A method according to any preceding claim, in which the metal layers are removed by a wet etching process.

5. A method according to any preceding claim, in which the first feature is formed by a dry etching process.

6. A method according to any preceding claim, in which the second feature is formed by a wet etching process.

7. A method according to any preceding claim, in which the substrate comprises a silicon substrate.

8. A method according to any of claims 2 to 7, in which the first, second and third metals are Nickel (Ni), Gold (Au) and Titanium (Ti), respectively.

9. A method according to any of claims 2 to 7, in which the first, second and third metals are Aluminium (Al), Gold (Au) and Chromium (Cr), respectively.

10. A method according to any preceding claim, further comprising the steps of:
forming a buffer layer on the surface of the substrate prior to applying the first mask;
removing exposed regions of the buffer layer prior to forming each of the first and second features in the substrate; and,
removing the remaining buffer layer after removing the layer of the first metal.

11. A method according to claim 10, in which at least a portion of the buffer layer is removed by a dry etching process.

12. A method according to claim 10 or 11, in which the buffer layer comprises a SiO₂ layer.

13. A method according to any preceding claim, in which one of the first and second features opens into the other of the first and second features.

14. A semiconductor substrate with a v-groove and a deep trench stop, the deep trench stop being substantially perpendicular to the v-groove, said v-goove and deep trench stop fabricated by a method according to any preceding claim.
